Europäisches Patentamt

European Patent Office

Office européen des brevets

(11) Veröffentlichungsnummer: **0 177 828 B1**

(12) # EUROPÄISCHE PATENTSCHRIFT

(45) Veröffentlichungstag der Patentschrift: **19.08.92**

(51) Int. Cl.$^5$: **H01S 3/085**, H01S 3/19

(21) Anmeldenummer: **85112048.5**

(22) Anmeldetag: **24.09.85**

(54) **Verbesserung zu einem Monomoden-Diodenlaser.**

(30) Priorität: **10.10.84 DE 3437209**

(43) Veröffentlichungstag der Anmeldung:
**16.04.86 Patentblatt 86/16**

(45) Bekanntmachung des Hinweises auf die
Patenterteilung:
**19.08.92 Patentblatt 92/34**

(84) Benannte Vertragsstaaten:
**DE FR GB**

(56) Entgegenhaltungen:
DE-A- 2 856 507
JP-A-59 126 693
US-A- 4 269 635

APPLIED PHYSICS LETTERS, Band 29, Nr. 5,
1. September 1976, Seiten 307-309, American
Institute of Physics, New York, US; J.N. WAL-
POLE et al.: "Distributed feedback
Pb1-xSnxTe double-heterostructure lasers"

APPLIED PHYSICS LETTERS, Band 27, Nr. 7,
1. Oktober 1975, Seiten 403-405, American
Institute of Physics, New York, US; M. NAKA-
MURA et al.: "Cw operation of distributed-
feedback GaAs-GaAlAs diode lasers at temperatures up to 300 K"

ELECTRONICS LETTERS, Band 20, Nr. 6, 15.
März 1984, Seiten 225-226, London, GB; L.D.
WESTBROOK et al.: "Continuous-wave operation of 1.5 mum distributed-feedback
ridge-waveguide lasers"

IEE PROCEEDINGS SECTION A - I, Band 132,
Nr. 2, Teil J, April 1985, Seiten 133-135, Old
Woking, Surrey, GB; R. SCHIMPE: "Design
considerations of the metal-clad ridge-
waveguide laser with distributed feedback"

(73) Patentinhaber: **SIEMENS AKTIENGESELL-
SCHAFT
Wittelsbacherplatz 2
W-8000 München 2(DE)**

(72) Erfinder: **Stegmüller, Bernhard, Dipl.-Ing.
Seefelder Strasse 8
W-8900 Augsburg(DE)**

EP 0 177 828 B1

## Beschreibung

Die vorliegende Erfindung bezieht sich auf einen Diodenlaser nach dem Oberbegriff des Patentanspruchs 1.

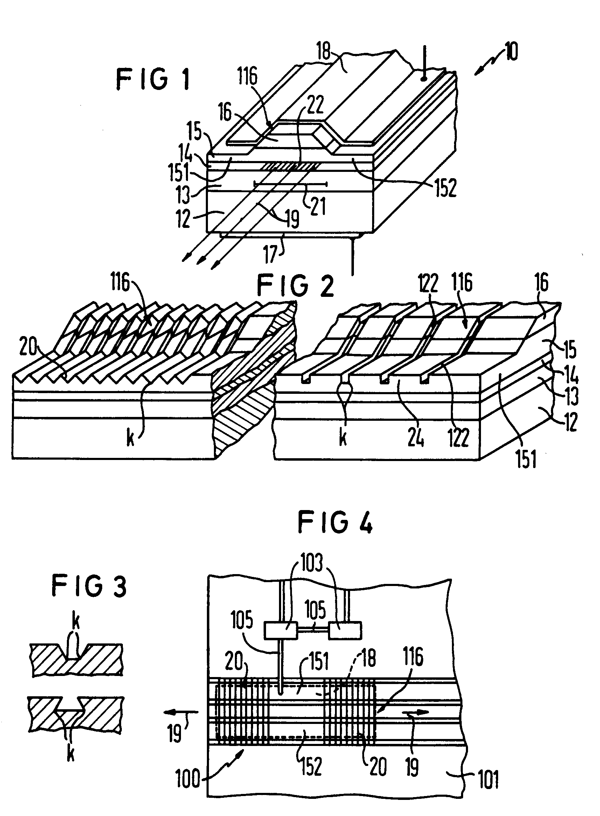

Dem Oberbegriff des Patentanspruchs 1 ist ein Monomoden-Diodenlaser nach der DE-OS 28 56 507 bzw. US-PS 4 352 187 zugrundegelegt. In diesen inhaltsgleichen Druckschriften ist ein Diodenlaser mit Doppel-Heteroschichtstruktur-Aufbau und Indexführung der erzeugten Laserstrahlung beschrieben. Es handelt sich dort um einen als MCRW-(metal cladded ridge waveguide-)Laser. Fig.1 zeigt einen solchen Diodenlaser 10 mit einem Substratkörper 12, mit den vier Schichten 13, 14, 15 und 16 der Doppel-Heteroschichtstruktur, mit einer ersten Elektrode 17, mit einer zweiten Elektrode 18 und mit 151 und 152 bezeichneten Seitenbereichen. Die aus der Fig.1 ersichtliche Form der Schicht 16 und eines angrenzenden Anteils der Schicht 15 ist insbesondere durch Ätzen erzeugt und wird als Steg 116 bezeichnet. Eine Ausführungsform einer solchen bekannten Laserdiode 10 kann auch derart sein, daß die Elektrode 18 sich nicht über die ganze Länge der Resonator-Zone, z.B. bis zur Vorderkante der Diode 10 erstreckt. Es kann dann z.B. durch Ausführung einer 'quantum well'-Struktur mit Dotierung im Teilbereich zwischen der (vorderen) Stirnfläche und der (Vorder-)Kante der Elektrode 18 dafür gesorgt werden, daß in diesem Teilbereich der Resonator-Zone keine wesentliche Absorption bzw. Dämpfung für die erzeugte Laserstrahlung vorliegt.

Die Resonator-Zone 22, aus der die Strahlung 19 austreten kann, erstreckt sich in Richtung dieser Strahlung 19, d.h. in Längsrichtung der Laserdiode 10 bzw. ihres Steges 116 durch diese hindurch, bis zu der in der Fig.1 abgeschnittenen Rückseite der Diode 10 bzw. des Substratkörpers 12 und seines Schichtaufbaues 13 bis 16. Diese Resonator-Zone 22 ist somit ein Streifen, so daß auch von einem Streifenlaser gesprochen wird. Dieser Streifen verläuft unterhalb des Steges. Diese Resonator-Zone 22 liegt im wesentlichen in der mit 14 bezeichneten Schicht der Doppel-Heteroschichtstruktur. Mit 21 ist auf die ungefähre Breite des in dieser Diode vorhandenen Stromflußbereiches hingewiesen. Wie für Streifenlaser bekannt, ist der Stromfluß zwischen den Elektroden 17 und 18 infolge der schon erwähnten Seitenbereiche 151 und 152 auf im wesentlichen die Breite der Resonator-Zone 22 eingegrenzt.

Die ebenfalls streifenförmigen Seitenbereiche 151 und 152 erstrecken sich seitlich neben und entlang dem Steg und der streifenförmigen Resonator-Zone 22. Das Vorhandensein dieser Seitenbereiche und insbesondere ihre den obengenannten Druckschriften entsprechenden Bemessungen wirken als Indexführung für die Resonator-Zone 22 bzw. auf die in der Laserdiode erzeugte und verlaufende Strahlung (von der in geradliniger Richtung fortgesetzt die Laserstrahlung 19 austritt).

Um in ihrer Eigenschaft als Monomoden-Strahlung verbesserte Laserstrahlung zu erzielen, sind für Laserdioden zahlreiche Vorschläge gemacht worden. Eine Vorschlagsvariante geht in Richtung auf die Verwendung gekoppelter, parallel angeordneter weiterer Laserstrukturen. Eine solche Struktur erfordert mehrere in der Laserdiode parallelgeführte laseraktive Zonen. Eine andere Variante ist die, innerhalb der laseraktiven Zone, d.h. innerhalb der Doppel-Heteroschichtstruktur, ein sogenanntes 'grating' vorzusehen. Ein 'grating' ist eine geometrische Struktur mit in Querrichtung zur Laserstrahlung verlaufenden, in Längsrichtung der Laserstrahlung wenigstens zu einem gewissen Maß periodisch verteilt angeordneten, für die Laserstrahlung wirksamen Diskontinuitäten.

Einzelheiten hierzu gehen aus den Druckschriften "IEEE Journal of Quantum Electronics", Vol.QE 9, No.9 (Sept.1973), 919-933 und Vol. QE-11, No.11 (November 1975), 867-873 hervor Die Herstellung eines solchen 'grating' innerhalb der Doppel-Heteroschichtstruktur,insbesondere innerhalb der Schicht 14 der Resonator-Zone 22, bedingt, daß im epitaktischen Herstellungsverfahren der Doppel-Heteroschichtstruktur 13 bis 16 eine Unterbrechung erfolgen muß. Nach auf dem Substrat 12 erfolgt Abscheidung der ersten Schichten der Doppel Heteroschichtstruktur muß das epitaktische Abscheiden unterbrochen werden, das 'grating' erzeugt werden und erst dann kann die Abscheidung der weiteren Schichten fortgesetzt werden. Diese Unterbrechung bedingt eine zwischenzeitliche Herausnahme des Substratkörpers aus der Epitaxie-Apparatur. Es ist ersichtlich, daß eine solche Maßnahme ganz erhebliche Nachteile für die Qualität der Doppel-Heteroschichtstruktur mit sich bringt und/ oder damit verbundenen erheblichen technologischen Mehraufwand zum Erreichen einer ungestörten Fortsetzung des Schichtaufbaues bedingt.

Aufgabe der vorliegenden Erfindung ist es, solche Maßnahmen anzugeben, mit denen (ebenfalls) eine insbesondere gesteigerte Verbesserung des Monomoden-Charakters der erzeugten Laserstrahlung erzielt wird, wobei der technologische Aufwand für diese neue Lösung auch möglichst weitgehend verringert sein soll.

Diese Aufgabe wird mit einer Laserdiode gelöst, die die Merkmale des Patentanspruchs 1 aufweist. Weitere Ausgestaltungen und Weiterbildungen der Erfindung gehen aus den Unteransprüchen hervor. Der Patentanspruch 8 betrifft eine monolithisch integrierte Anordnung einer Laserdiode mit weiteren Elementen.

Die vorliegende Erfindung baut auf einer bekannten Laserdiode der Fig.1 auf. Bei dieser neuen Laserdiode ist auch der Effekt genutzt, daß mit Hilfe einer Struktur nach Art eines 'grating' der Monomoden-Charakter erzeugter Laserstrahlung zumindest verbessert werden kann. Weiter liegt der Erfindung der Gedanke zugrunde, daß die aufgabengemäße Lösung derart sein muß, daß die Herstellung der Doppel-Heteroschichtstruktur in nur einem Verfahrensschritt ('one step'-Verfahren) durchzuführen ist, wobei die Einhaltung dieser Bedingung auch an der fertigen Diode noch nachweisbar ist.

Die gemäß einem Merkmal der Erfindung vorgesehene wenigstens eine Diskontinuitätenstruktur ist bei der erfindungsgemäßen Laserdiode in den Seitenbereichen 151 und 152 und/oder im Bereich des zwischen diesen Seitenbereichen 151, 152 vorhandenen Steges 116 vorgesehen. Eine solche erfindungsgemäße Diskontinuitäten-Struktur, die erfindungsgemäß außerhalb der Resonator-Zone 22 angeordnet ist, ist nach dem Prinzip einer DFB-(distributed feedback-)Struktur oder einer DBR-(distributed Bragg reflector-) Struktur ausgeführt. Diese Diskontinuitäten-Struktur ist im Bereich und über einen wesentlichen Anteil der Länge des Steges 116 bzw. der Seitenbereiche 151, 152 mit ausreichender Häufigkeit der Aufeinanderfolge von Diskontinuitäten verteilt angeordnet. Die einzelnen sich quer zur Längsrichtung der Diode erstreckenden Diskontinuitäten haben - in Längsrichtung der Diode gesehen - eine Abmessung zwischen einem Bruchteil einer halben Wellenlänge und einigen (bis zu drei) Wellenlängen, und zwar jeweils der im Halbleitermaterial geltenden Wellenlänge der Laserstrahlung. Die Aufeinanderfolge einer jeweiligen Anzahl einzelner Diskontinuitäten hat eine Periodizität, die auf diese Wellenlänge der Laserstrahlung abgestimmt ist. Es kann eine durchgehende Diskontinuitäten-Struktur mit ununterbrochen periodisch aufeinanderfolgenden Einzeldiskontinuitäten vorgesehen sein. Es kann aber ausreichend sein, lediglich abschnittsweise derartige periodische Folgen solcher Diskontinuitäten vorzusehen und zwischen solchen Diskontinuitäten-Abschnitten vergleichsweise zur Wellenlänge sehr viel größere (z.B. größer 100 Wellenlängen) Abstände vorzusehen. Die Anzahl der insgesamt vorzusehenden Diskontinuitäten, ihre Verteilung über die Länge der Diode, ihre Verteilung auf die Seitenbereiche und/oder den Steg, insbesondere auf die Flanken des Steges 116, die Tiefe solcher Diskontinuitäten und auch ihre - soweit noch frei wählbare - Nähe zur Resonator-Zone 22 sind so auszuwählen bzw. zu bemessen, daß eine solche Beeinflussungswirkung durch die erfindungsgemäß "außen" angebrachte eine oder mehreren Diskontinuitäten-Struktur(en) die aufgabengemäße monomoden-stabilisierende Wirkung auf die erzeugte Laserstrahlung auszuüben vermag.

Weitere Erläuterungen der Erfindung gehen aus der nachfolgenden, anhand der Figuren gegebenen Beschreibung eines Ausführungsbeispiels und Varianten der Erfindung hervor.

Fig.2 zeigt zwei Ausführungsformen.

Fig. 3 zeigt Beispiele.

Fig.4 zeigt die Aufsicht einer Diode nach der Erfindung.

Zur Fig.1 bereits beschriebene Bezugszeichen haben in den weiteren Figuren die jeweils gleiche Bedeutung wie bei der Diode nach Fig.1. Die Seitenansicht nach Fig.2 zeigt wieder das Substrat 12 und den Schichtaufbau der Schichten 13 bis 16 der Doppel-Heteroschichtstruktur und die Elektroden 17 und 18. Das Beispiel der Fig.2 zeigt abschnittsweise vorgesehene Diskontinuitäten-Strukturen, wie sie für die vorliegende Erfindung verwendet werden können. Die Wahl der geometrischen Struktur der zu verwendenden Diskontinuitäten-Struktur hängt im wesentli-wesentlichen davon ab, welche Strukturform an der im 'one step'-Verfahren schon hergestellten Laserdiode nach Fig.1 mit erst nachfolgenden Maßnahmen ohne Beeinträchtigung der schon vorhandenen Laserdiode am einfachsten, z.B. durch Ätzen, herzustellen ist und dennoch ausreichende Wirkung hat. Mit 20 ist eine Waschbrett-Struktur gezeigt. Die Struktur 24 ist eine Trapez-Struktur, wobei die Trapezform z.B. speziell eine Rechteckform sein kann.

Eine Struktur wie die mit 20 bezeichnete kann sich mehr oder weniger lang über die Länge der Diode hinweg erstreckend auf den Seitenstreifen 151 und 152 und/oder auf dem Steg 116, vorzugsweise eingeschlossen dessen Flanken, angeordnet sein. Eine wie mit 20 bezeichnete Diskontinuitäten-Struktur kann aber statt dessen dort auch abschnittsweise verteilt angeordnet sein, d.h. es kann eine mit 20 dargestellte Diskontinuität-Struktur auch mehrfach abschnittsweise (mit Abständen der Abschnitte voneinander) angeordnet sein. Eine (insgesamt) zu geringe Anzahl von Diskontinuitäten hätte noch zu geringe monomoden-stabilisierende Wirkung. Eine über das notwendige Maß hinaus weitere Erhöhung der Anzahl der Diskontinuitäten führt zu keiner wesentlichen Verbesserung mehr gegenüber dem Erreichten. Bei der dargestellten Waschbrett-Struktur 20 fallen die Abstände zwischen den Spitzen und das Maß für die Periodizität zusammen. Es sind hierfür Werte zwischen einer halben Wellenlänge und z.B. bis zu drei Wellenlängen vorzusehen. Bei einer dargestellten Trapezstruktur 24 ist zwar der die jeweilige einzelne Diskontinuität bildende kleine Einschnitt 122 in seiner Breite wiederum zwischen einem Bruchteil einer halben Wellenlänge und bis zu drei Wellenlängen zu bemessen. Es können aber die Mittenabstände benachbarter einzelner Diskontinuitäten 122 größer gewählt werden, solange wie auf die Wellenlänge der Laserstrahlung angepaßte Periodizität der Abstände der Diskontinuitäten 122 untereinander eingehalten bleibt. Auch für eine Struktur 24 gilt das zur Struktur 20 Gesagte hinsichtlich durchgehender Anordnung und abschnittsweiser Verteilung. Es ist aber darauf zu achten, daß eine mit größeren Abständen zwischen den einzelnen Diskontinuitäten 122 ausgestattete Diskontinuitäten-Struktur 24 hinsichtlich der Wirkung ihrer Diskontinuitäten 122 "verdünnt" ist, und es für die monomoden-stabilisierende Wirkung der Diskontinuitäten-Struktur bzw. ihrer betreffenden Abschnitte auf die Gesamtanzahl der Diskontinuitäten 122 ankommt.

In Fig.2 ist die Elektrode 18 der Übersichtlichkeit halber weggelassen. Sie ist eine auch die Strukturen 20 bis 24 überdeckende Metallisierung.

Fig.3 zeigt verschiedene weitere mögliche Querschnittsformen für die Einschnitte bzw. Diskontiuitäten 122. Alle diese Formen zeichnen sich dadurch aus, daß sie eine im wesentlichen ebene Grundfläche haben, so daß in das Maß der Periodizität jeweils zwei im Abstand voneinander, jedoch in engem Abstand voneinander, liegende Kanten k eingehen. Der Vollständigkeit halber sei aber darauf hingewiesen, daß eine Diskontinuität 122 auch Dreiecksform wie bei der Struktur 20 haben kann, wobei dann aber praktisch nur noch eine Kante k vorliegt. Ob sich ein Dreiecksquerschnitt der Struktur 20 oder ein Trapez-(Rechteck-)Quer-der Struktur 24 einfacher herstellen läßt, kann von der Wahl der Kristallrichtung und/oder dem speziellen Ätzmittel abhängen.

Fig.4 zeigt eine Aufsicht auf eine erfindungsgemäße Laserdiode 100, die sich in einem größeren Wafer 101 befindet, in den auch weitere optische und/oder elektronische Elemente integriert sein können. Die Streifen 151 und 152 sind derart in die Oberfläche hereingeätzt, daß dazwischen der Steg 116 stehenbleibt. Aus der Fig.4 geht auch eine Ausführungsform abschnittsweiser Anordnung von Diskontinuitäten-Strukturen, z.B. von Strukturen 20 hervor. Zur Realisierung eines DFB-Lasers sind die Diskontinuitäten im wesentlichen über die ganze Länge der Laserdiode 100 verteilt. Für DBR-Laser sind solche Strukturen an den jeweiligen Enden der Laserdiode - in Längsrichtung gesehen - im wesentlichen jeweils außerhalb der Elektrode 18 angeordnet. Erfindungsgemäß vorgesehene Diskontinuitäten-Strukturen 20, 24 bewirken auch die Funktion von Resonatorreflektoren.

Mit der Erfindung läßt sich eine Laserdiode 100 mit erfindungsgemäß vorgesehener, monomoden-stabilisierender Diskontinuitäten-Struktur in bzw. auf einem Wafer, auf dem sich die Doppel-Heteroschichtstruktur 13 bis 16 befindet, auch nachträglich herstellen. Die Epitaxie der Doppel-Heteroschichtstruktur erfolgt in einem Schritt ('one step'-Verfahren). Nachfolgend wird das Ätzen des Steges 116 und der jeweiligen Diskontinuitäten-Struktur 20, 24 und schließlich die Aufbringung der Elektrode 18 durchgeführt. Der Übersichtlichkeit halber ist die Elektrode 18 mit gestrichelter Umrandung dargestellt.

Die Laserdiode 100 kann ein Bauelement zu einer Gruppe monolithisch in dem Wafer 101 integrierter optischer und/oder elektronischer Bauelemente 103 sein, die durch ebenfalls integrierte Wellenleiter und/oder Leiterbahnen Leiterbahnen 105 verbunden sind.

**Patentansprüche**

1. Laserdiode mit einer mit einer Einschritt-Epitaxie herstellbaren Doppel-Heteroschichtstruktur, die eine Schicht (14) mit einer Resonator-Zone (22) darin und weitere Schichten (15, 16) umfaßt, wobei mit diesen weiteren Schichten ein streifenförmiger Steg (116) und seitlich daran angrenzende Seitenbereiche (151, 152) gebildet sind, und mit Elektroden (17, 18), von denen eine auf dem streifenförmigen Steg (116) und bis auf die Seitenbereiche (151, 152) hinabreichend aufgebracht ist, so daß eine streifenförmige Wellenführung hinsichtlich der Resonator-Zone (22) entsprechend dem Aufbau eines metal-cladded-ridge-waveguide-Lasers, abgekürzt MCRW-Lasers, vorliegt, **gekennzeichnet dadurch,** daß zur Bildung eines MCRW-DFB-Lasers bzw. MCRW-DBR-Lasers in der Oberfläche des Steges (116) und/oder der Seitenbereiche (151, 152) eine gitterartige Struktur (20, 24) aus in Längsrichtung des Steges (116) zumindest abschnittsweise in periodischer Abfolge angeordneten und quer zur Längsrichtung verlaufenden Diskontinuitäten angeordnet ist.

2. Laserdiode nach Anspruch 1, **dadurch gekennzeichnet,** daß die gitterartige Struktur (20, 24) in den Seitenbereichen (151, 152) angeordnet ist.

3. Laserdiode nach Anspruch 1, **dadurch gekennzeichnet,** daß die gitterartige Struktur (20, 24) in der Oberfläche des Steges (116) und wenigstens in dessen Flanken angeordnet ist.

4. Laserdiode nach einem der Ansprüche 1 bis 3, **dadurch gekennzeichnet,** daß die gitterartige Struktur (20) mehrere Abschnitte mit jeweils in periodischer Abfolge angeordneten Diskontinuitäten aufweist und daß zwischen diesen Abschnitten im Vergleich zur Wellenlänge große Abstände vorgesehen sind.

5. Laserdiode nach einem der Ansprüche 1 bis 4, **dadurch gekennzeichnet,** daß sich die auf dem Steg (116) aufgebrachte Elektrode (18) wenigstens an einem Ende des Steges (116) nicht bis zu dem entsprechenden Ende der Resonator-Zone (22) erstreckt und daß in dem Bereich zwischen diesem Ende dieser Elektrode (18) und diesem Ende der Resonator-Zone (22) eine aus in periodischer Abfolge angeordneten Diskontinuitäten gebildete gitterartige Struktur (20, 24) vorhanden ist.

6. Laserdiode nach einem der Ansprüche 1 bis 5, **dadurch gekennzeichnet,** daß jede Diskontinuität in einem senkrecht zu der Oberfläche der Seitenbereiche (151, 152) und seitlich längs des Steges (116) verlaufenden Schnitt ein dreieckiges Profil hat.

7. Laserdiode nach einem der Ansprüche 1 bis 5, **dadurch gekennzeichnet,** daß jede Diskontinuität in einem senkrecht zu der Oberfläche der Seitenbereiche (151, 152) und seitlich längs des Steges (116) verlaufenden Schnitt ein trapezförmiges Profil hat.

8. Monolithisch integrierte Anordnung aus einer Laserdiode nach einem der Ansprüche 1 bis 7 mit weiteren Elementen aus der Gruppe von optischem Bauelement, elektrischem Bauelement (103), Wellenleiter und Leiterbahn (105).

## Claims

1. Laser diode having a double hetero-layer structure which can be produced by means of single-step epitaxy and comprises a layer (14) having a resonator zone (22) therein and further layers (15, 16), said further layers forming a strip-shaped ridge (116) and lateral regions (151, 152) adjacent to the sides thereof, and having electrodes (17, 18) of which one is applied to the strip-shaped ridge (116) and reaches down as far as the lateral regions (151, 152), so that there is a strip-shaped guidance of waves with respect to the resonator zone (22) in accordance with the structure of a metal-clad ridge waveguide laser, abbreviated MCRW laser, characterised in that for the purpose of forming a MCRW-DFB laser or MCRW-DBR laser a grating-like structure (20, 24), consisting of discontinuities which are arranged in the longitudinal direction of the ridge (116) at least partially in periodic sequence and extend transverse to the longitudinal direction, is arranged in the surface of the ridge (116) and/or of the lateral regions (151, 152).

2. Laser diode according to Claim 1, characterised in that the grating-like structure (20, 24) is arranged in the lateral regions (151, 152).

3. Laser diode according to Claim 1, characterised in that the grating-like structure (20, 24) is arranged in the surface of the ridge (116) and at least in the flanks thereof.

4. Laser diode according to one of Claims 1 to 3, characterised in that the grating-like structure (20) has a plurality of sections each having discontinuities ranged in periodic sequence, and in that spacings that are large by comparison with the wavelength are provided between said sections.

5. Laser diode according to one of Claims 1 to 4, characterised in that at least at one end of the ridge (116) the electrode (18) applied to the ridge (116) does not extend up to the corresponding end of the resonator zone (22), and in that a grating-like structure (20, 24) formed from discontinuities arranged in periodic sequence is present in the region between said end of said electrode (18) and said end of the resonator zone (22).

6. Laser diode according to one of Claims 1 to 5, characterised in that each discontinuity has a triangular profile in a section extending perpendicular to the surface of the lateral regions (151, 152) and laterally along the ridge (116).

7. Laser diode according to one of Claims 1 to 5, characterised in that each discontinuity has a trapezoidal profile in a section extending perpendicular to the surface of the lateral regions (151, 152) and laterally along the ridge (116).

8. Monolithically integrated arrangement consisting of a laser diode according to one of Claims 1 to 7, having further elements from the group of optical component, electrical component (103), waveguide and printed conductor (105).

## Revendications

1. Diode laser comportant une hétérostructure de couches double, qui peut être fabriquée au moyen d'une épitaxie exécutée en une étape opératoire et comprend une couche (14) possédant une zone formant résonateur (22) et d'autres couches (15,16), avec lesquelles sont formées une barrette en forme de bande (116) et des zones latérales (151,152) contiguës à cette barrette, et comportant des électrodes (17,18), dont l'une est déposée sur la barrette en forme de bande (116) de manière à s'étendre jusqu'aux zones latérales (151,152) de sorte qu'on obtient un guidage des ondes selon une bande en rapport avec la zone formant résonateur (22), conformément à la structure d'un laser metal-cladded-ridge-waveguide, désigné de façon abrégée par MCRW,

caractérisée par le fait que pour la formation d'un laser MCRW-DFB ou d'un laser MCRW-DBR, dans la surface de la barrette (116) et/ou des zones latérales (151,152) est disposée une structure en forme de grille (20,24) formée par des discontinuités disposées, au moins par sections, selon une succession périodique dans la direction longitudinale de la barrette (116) et s'étendant transversalement par rapport à cette direction longitudinale.

2. Diode laser suivant la reendication 1, caractérisée par le fait que la structure en forme de grille (20,24) est disposée dans les zones latérales (151,152).

3. Diode laser suivant la revendication 1, caractérisée par le fait que la structure en forme de grille (20,24) est disposée dans la surface de la barrette (116) et au moins dans les flancs de cette dernière.

4. Diode laser suivant l'une des revendications 1 à 3, caractérisée par le fait que la structure en forme de grille (20) comporte plusieurs sections possédant des discontinuités disposées respectivement selon une séquence périodique et qu'entre ces sections, il est prévu des distances importantes par rapport à la longueur d'onde.

5. Diode laser suivant l'une des revendications 1 à 4, caractérisée par le fait que l'électrode (18) déposée sur la barrette (116) ne s'étend pas, au moins au niveau d'une extrémité de la barrette (116), jusqu'à l'extrémité correspondante de la zone formant résonateur (22) et que dans la zone située entre cette extrémité de cette électrode (18) et cette extrémité de la zone formant résonateur (22), il est prévu une structure en forme de grille (20,24) formée par des discontinuités disposées selon une séquence périodique.

6. Diode laser suivant l'une des revendications 1 à 5, caractérisée par le fait que chaque discontinuité possède un profil triangulaire, selon une coupe prise perpendiculairement à la surface des zones latérales (151,152) et latéralement le long de la barrette (116).

7. Diode laser suivant l'une des revendication 1 à 5, caractérisée par le fait que chaque discontinuité possède un profil trapézoïdal, selon une coupe prise perpendiculairement à la surface des zones latérales (151,152) et latéralement le long de la barrette (116).

8. Dispositif intégré monolithique formé d'une diode laser suivant l'une des revendications 1 à 7, comportant d'autres éléments du groupe incluant un composant optique, un composant électrique (103), un guide d'ondes et une voie conductrice (105).

FIG 1

FIG 2

FIG 4

FIG 3